# EUROPÄISCHE PATENTANMELDUNG

(11) **EP 2 159 857 A1**
(43) Veröffentlichungstag der Anmeldung: **03.03.2010**
(21) Anmeldenummer: 08015365.3
(22) Anmeldetag: 30.08.2008
(51) Int. Cl.: H01L 41/193, H01L 41/26, H01L 41/083

(54) **Elektromechanischer Wandler**

(71) Anmelder: Bayer MaterialScience AG, 51368 Leverkusen (DE)
(72) Erfinder: Jenninger, Werner Dr., 50674 Köln (DE); Wagner, Joachim Dr., 51061 Köln (DE); Dörr, Sebastian Dr., 40597 Düsseldorf (DE); Altstädt, Volker Prof., 95448 Bayreuth (DE); Lovera, Deliani, 95447 Bayreuth (DE)

(57) **Zusammenfassung**

Die vorliegende Erfindung betrifft einen elektromechanischen Wandler, ein Verfahren zu dessen Herstellung, dessen Verwendung sowie die Verwendung von polarisierten und/oder aufgeladenen Polycarbonaten, aromatischen Polyethern oder Polyetherimiden oder Mischungen davon als Elektret in einem elektromechanischen Wandler.
Der Wandler umfasst mindestens zwei Elektroden (4,5), zwei Polymerfilme (1,2) mit unterschiedlicher Ladung und einer dazwischen angeordnete Faserschicht (3).

## Beschreibung

Die vorliegende Erfmdung betrifft einen elektromechanischen, beispielsweise piezoelektrischen, Wandler, ein Verfahren zu dessen Herstellung sowie dessen Verwendung.

Die Fähigkeit einiger Materialien, ein elektrisches Potential aufgrund einer ausgeübten mechanischen Belastung auszubilden, bezeichnet man als Piezoelektrizität.

Etablierte piezoelektrische Materialien sind Blei-Zirkonium-Titanat (PZT) und fluorierte Polymere wie Polyvinylidenfluorid (PVDF).

Piezoelektrisches Verhalten wurde auch in geschäumtem, geschlossenporigen Polypropylen (PP) beobachtet. Um Piezoelektrizität zu erreichen, wird ein solcher Polypropylenschaum in einem hohen elektrischen Feld aufgeladen. Dadurch finden innerhalb der Poren elektrische Durchschläge statt, welche Makrodipole generieren und das Material makroskopisch polarisieren. Derartige Polypropylenferroelektrete können einen piezoelektrischen Koeffizienten von bis zu einigen Hundert Pikocoulomb pro Newton aufweisen. Um die Sensitivität der Sensorwirkung weiter zu erhöhen, wurden Mehrschichtsysteme aus mehreren übereinander gestapelten Schäumen entwickelt. Allerdings ist die Verwendung solcher Polymerferroelektrete insbesondere aufgrund der geringen thermischen Stabilität von Polypropylen auf Temperaturen von weniger als 70°C eingeschränkt. Andere untersuchte Materialien wie z.B. zelluläres Polyethylenterephthalat und zelluläre Cyloolefincopolymere erwiesen sich als relativ steif und zeigten nur einen ziemlich kleinen piezoelektrischen Koeffizienten.

Weiterhin zeigen Doppelschicht-Anordnungen, bei denen eine weiche Polypropylenschicht mit einer harten Polystyrolschicht verbunden ist, Piezoelektrizität. Die Verwendung einer derartigen Doppelschicht-Anordnung ist jedoch ebenfalls aufgrund der geringen thermischen Stabilität von Polypropylen auf Temperaturen von weniger als 70°C einschränkt.

Ferner verwendet man Fluorpolymerfilme zur Verbesserung der Ladungsspeicherung und zur Verbesserung der Anhaftung von herkömmlicherweise nur offenporig herstellbaren Fluorpolymerschäumen an den Elektroden in Mehrschichtanordnungen aus weichen, porösen Filmen und harten Fluorpolymerschichten und in Sandwich-Systemen mit einem weichen, porösen Film zwischen zwei kompakten Fluorpolymerfilmen.

Kacprzyk et al. (Journal of Electrostatics, 1997, 39, Seiten 33 bis 44) beschreiben eine Zweischichtanordnung mit einer aufgeladenen Polytetrafluorethylenschicht und einer elastischen Schicht aus einem Polypropylenvlies.

Von Seggern et al. (J. Appl. Phys., 2006, 99, 024102) beschreiben eine Dreischichtanordnung mit zwei äußeren Fluorethylenpropylenfilmen und einem mittleren faserförmigen Polytetrafluorethylenfilm.

Die Herstellung von Filmen und Fasern aus fluorierten Polymeren ist jedoch aufwändig und mit hohen Kosten verbunden. Darüber hinaus setzen auf fluorierten und anderen halogenierten Polymeren basierende Anordnungen, insbesondere beim Abbrand, toxische und umweltschädliche Verbindungen frei.

Aufgabe der vorliegenden Erfmdung war daher, einen elektromechanischen, beispielsweise piezoelektrischen, Wandler zur Verfügung zu stellen, welcher einen möglichst hohen und möglichst zeit- und/oder temperaturbeständigen piezoelektrischen Koeffizienten aufweist, mit geringen Kosten und/oder einem einfachen Verfahren hergestellt werden kann, und einen möglichst geringen Anteil an fluorierten, insbesondere halogenierten, Polymeren aufweist.

Diese Aufgabe wird durch einen erfmdungsgemäßen elektromechanischen, beispielsweise piezoelektrischen, Wandler gelöst, welcher
- mindestens zwei Elektroden,
- mindestens zwei Polymerfilme, die eine Ladung mit unterschiedlichem Vorzeichen aufweisen, und
- mindestens eine Faserschicht
aufweist,
wobei eine Faserschicht zwischen zwei Polymerfilmen, insbesondere angrenzend, angeordnet ist,
wobei jeder Polymerfilm eine Elektrode kontaktiert, und der dadurch gekennzeichnete ist, dass
die Faserschicht aus einem unfluorierten Polymer oder aus einer Mischung aus mehreren unfluorierten Polymeren (Polymerblend) ausgebildet ist, und/oder
die Polymerfilme aus einem unfluorierten Polymer oder aus einer Mischung aus mehreren unfluorierten Polymeren (Polymerblend) ausgebildet sind.

Im Rahmen der vorliegenden Erfmdung hat sich überraschenderweise herausgestellt, dass ein erfindungsgemäßer Wandler einen hohen und zeitbeständigen piezoelektrischen Koeffizienten aufweist, wenn die Polymerfilme und/oder die Faserschicht aus einem unfluorierten Polymer oder aus einer Mischung aus mehreren unfluorierten Polymeren beziehungsweise aus einem unhalogenierten Polymer oder aus einer Mischung aus mehreren unhalogenierten Polymeren ausgebildet sind.

Vorteilhafterweise ermöglicht dies, den Anteil von fluorhaltigen beziehungsweise halogenhaltigen Komponenten deutlich zu verringern oder sogar den Einsatz von fluorierten oder halogenierten Polymeren beziehungsweise von fluorhaltigen oder halogenhaltigen Komponenten zu vermeiden.

Wenn eine mechanische Beanspruchung auf einen derartigen Wandler ausgeübt wird, so deformiert sich der Wandler entlang seiner Dicke und ein starkes elektrisches Signal kann an den Polymerfilmen detektiert werden. Damit wird mechanische Energie in elektrische Energie umgewandelt. Diesen elektromechanischen, insbesondere piezoelektrischen, Effekt bezeichnet man als "direkten" piezoelektrischen Effekt. Der erfmdungsgemäße Wandler kann folglich sowohl als Generator als auch als Sensor eingesetzt werden.

Unter Ausnutzung des entgegengesetzten elektromechanischen, insbesondere piezoelektrischen, Effekts, nämlich der Umwandlung von elektrischer Energie in mechanische Energie, kann der erfmdungsgemäße Wandler andererseits gleichermaßen als Aktuator dienen.

Ein erfindungsgemäßer Wandler kann daher vorteilhafterweise als Sensor, Generator und/oder Aktuator in elektromechanischen, beispielsweise piezoelektrischen, Anwendungen Verwendung finden.

Bei dem erfindungsgemäßen Wandler hat die Faserschicht die Aufgabe, den Wandler entlang seiner Dicke weicher zu machen und damit dessen Elastizitätsmodul zu erniedrigen. Außerdem ermöglicht die Porosität der Faserschicht den Polungsprozess in den Hohlräumen zwischen den Fasern. Darüber hinaus ermöglicht es diese Faserschicht, die nach dem Aufladungsprozess in den Polymerfilmen gebildeten Ladungsschichten zu separieren.

Die Faserschicht kann im Rahmen der vorliegenden Erfmdung ein faserhaltiger Textilstoff sein. Insbesondere kann es sich bei der Faserschicht um ein Gewebe und/oder Gestrick und/oder Gewirk und/oder Vliesstoff und/oder Filz und/oder ein Spinnfaservlies handeln. Die Faserschicht kann grundsätzlich mittels konventionellen Verfahren, beispielsweise mittels Meltblown-, Spunbond-Methoden, hergestellt werden.

Im Rahmen einer bevorzugten Ausführungsform der vorliegenden Erfmdung ist die Faserschicht eine mittels Elektrospinnen hergestellte Faserschicht, insbesondere ein mittels Elektrospinnen hergestellter Vliesstoff.

Im Rahmen der vorliegenden Erfindung kann die Faserschicht grundsätzlich aus jedem, insbesondere unfluorierten beziehungsweise unhalogenierten, Polymer ausgebildet sein, welches geeignet ist, den Elastizitätsmodul des Wandlers zu erniedrigen, einen Polungsprozess in den Hohlräumen zwischen den Fasern zu ermöglichen und die nach dem Aufladungsprozess in den Polymerfilmen gebildeten Ladungsschichten zu separieren. Daher eignen sich im Rahmen der vorliegenden Erfmdung nicht nur synthetische, sondern auch natürliche Polymere mit diesen Eigenschaften, beispielsweise Wolle oder Seide, zur Ausbildung der erfmdungsgemäßen Faserschicht.

Im Rahmen einer weiteren bevorzugten Ausführungsform der vorliegenden Erfindung umfasst die Faserschicht ein Elastomer. Beispielsweise kann die Faserschicht aus einem Elastomer ausgebildet sein.

Im Rahmen einer weiteren Ausführungsform der vorliegenden Erfindung ist die Faserschicht aus einem Polycarbonat, einem Polyurethan, einem, insbesondere aromatischen, Polyether, einem Polyimid, insbesondere Polyetherimid, oder einem Polyolefm oder aus einer Mischung davon ausgebildet. Beispielsweise kann die Faserschicht aus einem Polycarbonat, aus Polypropylen, aus Polystyrol, aus Polyphenylenoxid oder aus Polyetherimid ausgebildet sein. Vorzugsweise ist die Faserschicht aus einem Polycarbonat, einem Polyurethan, einem aromatischen Polyether oder einem Polyimid, insbesondere Polyetherimid, oder aus einer Mischung davon ausgebildet. Beispielsweise kann die Faserschicht aus einem Polycarbonat, aus Polyphenylenoxid oder aus Polyetherimid oder aus einer Mischung davon, insbesondere aus einem Polycarbonat, ausgebildet sein.

Geeignete Polycarbonate sind beispielsweise durch Reaktion von Kohlensäurederivaten, wie Diphenylcarbonat, Dimethylcarbonat oder Phosgen, mit Polyolen, bevorzugt Diolen, erhältlich. Beispiele für geeignete Diole sind dabei Ethylenglykol, 1,2- Propandiol, 1,3-Propandiol, 1,3-Butandiol, 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A, Bisphenol F, Trimethyl-cyclohexyl-bisphenol (Bisphenol-TMC), Mischungen aus diesen und lactonmodifizierte Diole. Bevorzugt sind Polycarbonate hergestellt Bisphenol A, Bisphenol F, Trimethyl- cyclohexyl-bisphenol (Bisphenol-TMC) und Mischungen daraus und ganz besonders bevorzugt sind Polycarbonate basierend aus Bisphenol A.

Im Rahmen einer weiteren Ausführungsform der vorliegenden Erfmdung ist die Faserschicht aus einem Homopolymeren ausgebildet.

Im Rahmen einer noch weiteren Ausführungsform der vorliegenden Erfindung umfasst das Polymer oder das Polymergemisch der Faserschicht mindestens ein Additiv zur Verbesserung der Elektret- und/oder elektromechanischen, beispielsweise piezoelektrischen, Eigenschaften. Das Additiv kann dabei jegliche Polymereigenschaften sowie Parameter verbessern, die eine Auswirkung auf die elektromechanischen, beispielsweise piezoelektrischen, Eigenschaften des Materials haben. Beispielsweise kann das Additiv die Dielektrizitätskonstante, den Elastizitätsmodul, das viskoelastische Verhalten, die Maximaldehnung und/oder die dielektrische Durchschlagsfestigkeit des Polymers beziehungsweise des Polymergemisches verbessern. Vorzugsweise wird ein Additiv eingesetzt, welches die Dielektrizitätskonstante und/oder die elektrische Leitfähigkeit und/oder das Elastizitätsmodul des Polymers erniedrigt und/oder die dielektrische Durchschlagsfestigkeit des Polymers erhöht. Beispielsweise können Tonpartikel, feine keramische Pulver und/oder Weichmacher wie Kohlenwasserstofföle, Mineralöle, Silikonöle und/oder Silikonelastomere, insbesondere mit hohem Molekulargewicht, als Additive eingesetzt werden. Durch die Auswahl von mehreren Additiven können vorteilhafterweise mehrere Materialeigenschaften gleichzeitig verbessert werden. Da die Molzahl der Additive verglichen mit der der Polymere der Faserschicht gering ist, können im Rahmen der vorliegenden Erfmdung grundsätzlich auch Additive eingesetzt werden, welche Fluoratome beziehungsweise Halogenatome enthalten. Um den Anteil von fluorhaltigen beziehungsweise halogenhaltigen Komponenten weiter zu verringern, umfasst das Polymer oder das Polymergemisch der Faserschicht vorzugsweise ein Additiv, welches nur wenige oder keine Fluoratome, beziehungsweise Halogenatome, aufweist.

Bei den Polymerfilmen handelt es sich vorzugsweise um kompakte Polymerfilme. Dabei bedeutet der Begriff "kompakt" im Sinn der vorliegenden Erfmdung, dass die Polymerfilme möglichst wenige, insbesondere keine, Einschlüsse wie Gasblasen aufweisen.

Im Rahmen der vorliegenden Erfmdung können die Polymerfilme grundsätzlich durch alle bekannten Verfahren zur Herstellung von, insbesondere dünnen, Filmen hergestellt werden. Beispielsweise können die Polymerfilme unabhängig voneinander über Extrusion, Rakeln, insbesondere Lösungsrakeln, Schleudern, insbesondere Lackschleudern, oder Sprühen hergestellt werden. Im Rahmen der vorliegenden Erfindung können jedoch auch kommerziell erhältliche Polymerfilme verwendet werden.

Die Polymerfilme können im Rahmen der vorliegenden Erfmdung unabhängig voneinander eine Filmdicke von ≥ 10 µm bis ≤ 150 µm, beispielsweise von ≥ 20 µm bis ≤ 70 µm, insbesondere von ≥ 20 µm bis ≤ 50 µm, aufweisen.

Im Rahmen der vorliegenden Erfindung können die Polymerfilme grundsätzlich aus jedem, insbesondere unfluorierten beziehungsweise unhalogenierten, Polymer beziehungsweise Polymergemisch ausgebildet sein, welches geeignet ist, Ladung über einen langen Zeitraum, beispielsweise einige Monate oder Jahre, zu halten.

Im Rahmen einer Ausführungsform der vorliegenden Erfmdung sind die Polymerfilme unabhängig voneinander aus einem Polycarbonat, einem, insbesondere aromatischen, Polyether, einem Polyimid, insbesondere einem Polyetherimid, oder einem Polyolefm oder aus einer Mischung davon ausgebildet. Beispielsweise können die Polymerfilme unabhängig voneinander aus einem Polycarbonat, aus Polypropylen, aus Polystyrol, aus Polyphenylenoxid oder aus Polyetherimid ausgebildet sein.

Im Rahmen einer bevorzugten Ausführungsform der vorliegenden Erfmdung sind die Polymerfilme unabhängig voneinander aus einem Polycarbonat, einem aromatischen Polyether oder einem Polyimid, insbesondere einem Polyetherimid, oder aus einer Mischung davon ausgebildet. Beispielsweise können die Polymerfilme unabhängig voneinander aus einem Polycarbonat, aus Polyphenylenoxid oder aus Polyetherimid oder aus einer Mischung davon, insbesondere aus einem Polycarbonat, ausgebildet sein. Derartige Polymere können die eingebrachte Polarisierung vorteilhafterweise über lange Zeit halten.

Geeignete Polycarbonate sind beispielsweise durch Reaktion von Kohlensäurederivaten, wie Diphenylcarbonat, Dimethylcarbonat oder Phosgen, mit Polyolen, bevorzugt Diolen, erhältlich. Beispiele für geeignete Diole sind dabei Ethylenglykol, 1,2- Propandiol, 1,3-Propandiol, 1,3-Butandiol, 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A, Bisphenol F, Trimethyl-cyclohexyl-bisphenol (Bisphenol-TMC), Mischungen aus diesen und lactonmodifizierte Diole. Bevorzugt sind Polycarbonate hergestellt Bisphenol A, Bisphenol F, Trimethyl- cyclohexyl-bisphenol (Bisphenol-TMC) und Mischungen daraus und ganz besonders bevorzugt sind Polycarbonate basierend aus Bisphenol A.

Im Rahmen einer weiteren Ausführungsform der vorliegenden Erfmdung sind die Polymerfilme unabhängig voneinander aus einem Homopolymeren ausgebildet.

Im Rahmen einer noch weiteren Ausführungsform der vorliegenden Erfindung umfasst das Polymer oder das Polymergemisch der Polymerfilme mindestens ein Additiv zur Verbesserung der Elektret- und/oder elektromechanischen, beispielsweise piezoelektrischen, Eigenschaften. Das Additiv kann dabei jegliche Polymereigenschaften sowie Parameter verbessern, die eine Auswirkung auf die elektromechanischen, beispielsweise piezoelektrischen, Eigenschaften des Materials haben. Beispielsweise kann das Additiv die Elektreteigenschaften, die Dielektrizitätskonstante, den Elastizitätsmodul, das viskoelastische Verhalten, die Maximaldehnung und/oder die dielektrische Durchschlagsfestigkeit des Polymers beziehungsweise des Polymergemisches verbessern. Vorzugsweise werden ein Additiv oder mehrere Additive eingesetzt, welche die Elektreteigenschaften verbessern, das heißt, welche die Ladungsspeicherfähigkeit erhöhen, die elektrische Leitfähigkeit erniedrigen und/oder die dielektrische Durchschlagsfestigkeit des Polymers erhöhen. Beispielsweise können Tonpartikel, feine keramische Pulver und/oder Weichmacher wie Kohlenwasserstofföle, Mineralöle, Silikonöle und/oder Silikonelastomere, insbesondere mit hohem Molekulargewicht, als Additive eingesetzt werden. Durch die Auswahl von mehreren Additiven können vorteilhafterweise mehrere Materialeigenschaften gleichzeitig verbessert werden. Da die Molzahl der Additive verglichen mit der der Polymere der Polymerschicht gering ist, können im Rahmen der vorliegenden Erfmdung grundsätzlich auch Additive eingesetzt werden, welche Fluoratome beziehungsweise Halogenatome enthalten. Um den Anteil von fluorhaltigen beziehungsweise halogenhaltigen Komponenten weiter zu verringern, umfasst das Polymer oder das Polymergemisch der Polymerfilme vorzugsweise ein Additiv, welches nur wenige oder keine Fluoratome, beziehungsweise Halogenatome, aufweist.

Neben den zwei Polymerfilmen, zwischen denen die Faserschicht angeordnet ist, kann der erfmdungsgemäße Wandler einen oder mehrere weitere Polymerfilme aufweisen. Ein solcher weiterer Polymerfilm kann beispielsweise auf der Seite eines an die Faserschicht angrenzenden Polymerfilms angeordnet sein, welche der an die Faserschicht angrenzenden Seite gegenüber liegt.

Die Elektroden können im Rahmen der vorliegenden Erfmdung auch strukturiert sein. Beispielsweise können die Elektroden derart strukturiert sein, dass der Wandler aktive und passive Bereiche aufweist. Insbesondere können die Elektroden derart strukturiert sein, dass, insbesondere im Sensor-Modus, die Signale ortsaufgelöst detektiert und/oder, insbesondere im Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

Im Rahmen einer weiteren Ausführungsform des erfmdungsgemäßen Wandlers weist der Wandler zwei oder mehr aufeinander gestapelte Polymerfilm-Faserschicht-Polymerfilin-Einheiten auf. Insbesondere wird dabei jeder Polymerfilm von einer Elektrode kontaktiert. Vorzugsweise sind dabei zwei benachbarte Polymerfilme unterschiedlicher Polymerfilm-Faserschicht-Polymerfilm-Einheiten mit einer gleichen Polarisation aufgeladen. Insbesondere können dabei zwei benachbarte Polymerfilme unterschiedlicher Polymerfilm-Faserschicht-Polymerfilm-Einheiten die gleiche Elektrode kontaktieren.

Ein weiterer Gegenstand der vorliegenden Erfmdung ist ein Verfahren zur Herstellung eines erfindungsgemäßen Wandlers. Das erfindungsgemäße Verfahren umfasst dabei die Verfahrensschritte:
a) Bereitstellen von mindestens zwei Polymerfilmen,
b) gegebenenfalls Tempern der Polymerfilme,
c1) Bereitstellen einer Faserschicht,
c2) Anordnen der Faserschicht auf einem der Polymerfilme,
c3) Anordnen des zweiten Polymerfilms auf der Faserschicht-Polymerfilin-Anordnung
d) Zusammenfügen der Polymerfilm-Faserschicht-Polymerfilm-Anordnung unter Anwendung eines erhöhten Drucks und/oder einer erhöhten Temperatur, und
e) Aufladen der Polymerfilm-Faserschicht-Polymerfilm-Anordnung.
wobei die Elektroden (4, 5) bereits mit den Polymerfilmen (1, 2) bereitgestellt werden oder nach dem Anordnen oder nach dem Zusammenfügen oder nach dem Aufladen in Kontakt mit den Polymerfilmen (1, 2) gebracht werden.

Die Polymerfilme können dabei durch eine bekannte Herstellungsmethode für, insbesondere dünne, Filme, beispielsweise durch Extrusion, Rakeln, insbesondere Lösungsrakeln, Schleudern, insbesondere Lackschleudern, oder Sprühen, oder durch den Einsatz von kommerziell erhältlichen Polymerfilmen, bereitgestellt werden.

Zur Verbesserung des Elektretverhaltens der Polymerfilme hat es sich im Rahmen der vorliegenden Erfmdung als vorteilhaft herausgestellt, wenn die Polymerfilme vor dem Aufladungsprozess bevorzugt für ≥ 5 min bis ≤ 24 h bei ≥ 90 °C bis ≤ 200 °C, zum Beispiel ≥ 10 min bis ≤ 12 h bei ≥ 120 °C bis ≤ 180 °C, besonders bevorzugt ≥ 10 min bis ≤ 40 min bei ≥ 135 °C bis ≤ 150 °C getempert werden.

Die Elektroden können im Rahmen der vorliegenden Erfmdung Metalle, Halbleiter und/oder elektrisch leitende Polymere umfassen oder daraus ausgebildet sein. Vorzugsweise handelt es sich bei den Elektroden um eine dünne Elektrodenmaterialschicht. Vorzugsweise ist eine derartige Elektrodenmaterialschicht auf der Seite eines Polymerfilms ausgebildet, welche im herzustellenden Wandler der an die Faserschicht angrenzenden Seite des Polymerfilms gegenüberliegt. Die Elektrodenmaterialschicht kann beispielsweise durch Sputtern, Aufdampfen, Rakeln auf einen Polymerfilm aufgebracht werden. Insofern der erfmdungsgemäße Wandler zwei oder mehr aufeinander gestapelte Polymerfilm-Faserschicht-Polymerfilm-Einheiten aufweist, können zwei benachbarte Polymerfilme unterschiedlicher Polymerfilm-Faserschicht-Polymerfilm-Einheiten die gleiche Elektrode kontaktieren.

Im Rahmen einer bevorzugten Ausführungsform können die zwei Verfahrensschritte c1) und c2) in einem Verfahrensschritt durchgeführt werden, indem beispielsweise eine Faserschicht mittels Elektroverspinnen einer Polymerlösung direkt auf einem der Polymerfilme aufgebracht wird.

Als Verfahren zur Herstellung von Fasern eignet sich beispielsweise ein Meltblow- oder Spunbond-Verfahren oder ein Mehrkomponenten-Verfahren oder Elektroverspinnen. Beispielsweise kann die Faserschicht mittels eines Meltblow- oder Spunbond-Verfahrens, in dem eine Polymerschmelze mit hohem Druck durch eine oder mehrere Düsen gepresst wird, oder mittels eines Mehrkomponenten-Verfahrens, in dem Fasern mit Komponenten aus unterschiedlichen Polymeren durch Extrusion, insbesondere mittels Wasserdüsen, hergestellt werden, direkt auf einem der Polymerfilme aufgebracht werden.

Im Rahmen einer weiteren bevorzugten Ausführungsform der vorliegenden Erfindung wird die Faserschicht mittels Elektroverspinnen einer Polymerlösung oder Polymerschmelze direkt auf einem der Polymerfilme aufgebracht.

Dabei beruht der Elektrospinnprozess auf der Bildung von Polymerfilamenten, welche entstehen, wenn eine Polymerlösung oder Polymerschmelze einer hohen elektrischen Spannung ausgesetzt wird. Der Standardaufbau besteht bei Elektrospinnen aus einer Spritze, welche die Polymerlösung oder Polymerschmelze enthält, einer Hochspannungsquelle und einem geerdeten Kollektor. Wenn die Lösung oder Schmelze einer hohen elektrischen Spannung ausgesetzt wird, bildet sich am Spritzenende ein elektrisch geladener Lösungsstrahl beziehungsweise Schmelzestrahl, welcher sich von der Spitze wegbewegt. Dabei wird er zum einen verlängert und zum anderen konusförmig von der Spritze weggepeitscht. Gleichzeitig verdampft das Lösungsmittel beziehungsweise erstarrt die Schmelze und die Fasern werden auf dem Kollektor abgelegt. Aufgrund des Elektrospinnprozesses sind auf diesem Wege hergestellte Fasern - im Gegensatz zu über Meltblown- und Spunbond-Verfahren hergestellten Fasern - bereits von Natur aus aufgeladen. Die Fähigkeit des Materials, die intrinsische Ladung zu speichern, hängt zum einem von seinem Elektretverhalten und zum anderen von den Lagerungsbedingungen ab. Die in den Fasern verbleibende Ladung kann das elektromechanische, beispielsweise piezoelektrische, Verhalten der gesamten Anordnung in positiver Weise beeinflussen.

Zum Elektroverspinnen eines Polymers oder einer Polymermischung kann ein Lösungsmittel oder eine Lösungsmittelmischung verwendet werden. Zum Elektronenspinnen von Polycarbonaten kann beispielsweise Tetrahydrofuran, Dimethylformamid, Dichlormethan oder Chloroform oder eine Mischung davon verwendet werden. Die Polymerkonzentration kann beim Elektrospinnen in einem Bereich von ≥ 5 Gewichtsprozent bis ≤ 30 Gewichtsprozent, beispielsweise von ≥ 10 Gewichtsprozent bis ≤ 25 Gewichtsprozent, insbesondere von ≥ 15 Gewichtsprozent bis ≤ 20 Gewichtsprozent, liegen. Die Spannung kann beim Elektrospinnen in einem Bereich von ≥ 15 kV bis ≤ 40 kV, beispielsweise von ≥ 20 kV bis ≤ 35 kV, insbesondere von ≥ 25 kV bis ≤ 30 kV, liegen. Die Flussrate kann beim Elektrospinnen in einem Bereich von ≥ 0,001 ml/min bis ≤ 2 ml/min, beispielsweise von ≥ 0,005 ml/min bis ≤ 1 ml/min, insbesondere von ≥ 0,01 ml/min bis ≤ 0,5 ml/min, liegen. Die Abstand zwischen Spritze und Kollektor kann beim Elektrospinnen in einem Bereich von ≥ 1 cm bis ≤ 35 cm, beispielsweise von ≥ 5 cm bis ≤ 30 cm, insbesondere von ≥ 10 cm bis ≤ 25 cm, liegen.

Das Zusammenfügen der Polymerfilm-Faserschicht-Polymerfilm-Anordnung unter Anwendung eines erhöhten Drucks und/oder einer erhöhten Temperatur kann beispielsweise zwischen zwei heißen, sich drehenden Zylindern erfolgen. Der Druck und die Temperatur werden vorzugsweise dabei derart ausgewählt, dass sich die Polymerfilme mit der Faserschicht verbinden, wobei die Faserstruktur der Faserschicht nicht zerstört wird.

Das Aufladen der Polymerfilm-Faserschicht-Polymerfilm-Anordnung kann im Rahmen der vorliegenden Erfindung beispielsweise durch Triboaufladung, Elektronenstrahlbeschuss, Anlegen einer elektrischen Spannung an die Elektroden oder Coronoentladung erfolgen. Im Rahmen einer Ausführungsform der vorliegenden Erfmdung erfolgt das Aufladen der Polymerfilm-Faserschicht-Polymerfilm-Anordnung durch eine Zweielektroden-Corona-Anordnung. Dabei kann die Nadelspannung mindestens ≥ 20 kV, beispielsweise mindestens ≥ 25 kV, insbesondere mindestens ≥ 30 kV, betragen. Die Aufladezeit kann dabei mindestens ≥ 20 s, beispielsweise mindestens ≥ 30 s, insbesondere mindestens ≥ 1 min, betragen.

Ein weiterer Gegenstand der vorliegenden Erfindung ist die Verwendung eines, insbesondere polarisierten und/oder aufgeladenen, Polycarbonats, eines, insbesondere polarisierten und/oder aufgeladenen, aromatischen Polyethers, insbesondere Polyphenylenoxid, oder eines, insbesondere polarisierten und/oder aufgeladenen, Polyimids, insbesondere Polyetherimids, oder einer Mischung davon, als Elektret in einem elektromechanischen, beispielsweise piezoelektrischen, Wandler. Vorzugsweise wird dabei ein Polycarbonat oder eine Polycarbonatmischung als Elektret in einem elektromechanischen, beispielsweise piezoelektrischen, Wandler verwendet.

Verwendung eines erfmdungsgemäßen Wandlers als Sensor, Generator und/oder Aktuator, beispielsweise im elektromechanischen und/oder elektroakustischen Bereich, insbesondere im Bereich der Akustik, des Ultraschalls, der medizinischen Diagnostik, der akustischen Mikroskopie, der Sensorik, der Robotik und/oder der Kommunikationstechnologie, insbesondere in Lautsprechern, Schwingungswandlern, Lichtdeflektoren, Membranen, Modulatoren für Glasfaseroptik, pyroelektrischen Detektoren, Kondensatoren und Kontrollsystemen.

### Zeichnungen und Beispiele

Der Aufbau und die Herstellung eines erfindungsgemäßen elektromechanischen, beispielsweise piezoelektrischen, Wandlers wird anhand der Zeichnungen und der folgenden Versuchsbeschreibung näher erläutert. Dabei ist zu beachten, dass die Zeichnungen und die Versuchsbeschreibung nur einen beschreibenden Charakter haben und nicht dazu gedacht sind, die Erfindung in irgendeiner Form einzuschränken.

### Zeichnungen

Es zeigen:
- Fig. 1a: einen schematischen Querschnitt durch die Polymerfilm-Faserschicht-Polymerfilm-Anordnung eines erfindungsgemäßen Wandlers vor dem Aufladungsprozess;
- Fig. 1b: einen schematischen Querschnitt durch die in Fig. 1a gezeigte Polymerfilm-Faserschicht-Polymerfilm-Anordnung eines erfindungsgemäßen Wandlers nach dem Aufladungsprozess;
- Fig. 1c: einen schematischen Querschnitt durch einen erfindungsgemäßen Wandler mit Elektroden; und
- Fig. 2: einen schematischen Querschnitt durch einen erfindungsgemäßen Wandler mit drei aufeinander gestapelten Polymerfilm-Faserschicht-Polymerfilm-Einheiten.

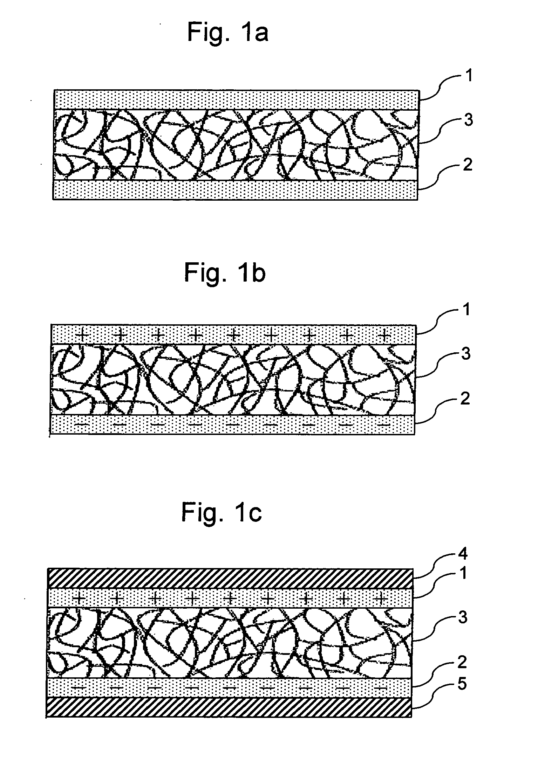

Figur 1a zeigt, dass ein erfindungsgemäße Wandler mindestens zwei Polymerfilme **1, 2** und eine Faserschicht **3** aufweist. Dabei ist die Faserschicht **3** zwischen zwei Polymerfilmen **1, 2** angrenzend angeordnet. Erfmdungsgemäß kann die Faserschicht **3** dabei aus einem unfluorierten Polymer oder aus einer Mischung aus mehreren unfluorierten Polymeren ausgebildet sein. Wie die nachfolgend beschriebenen Versuche zeigen, können darüber hinaus auch die Polymerfilme **1, 2** aus einem unfluorierten Polymer oder aus einer Mischung aus mehreren unfluorierten Polymeren ausgebildet sein.

Figur 1b zeigt die Ladungsverteilung nach dem Aufladen der Polymerfilm-**1**-Faserschicht-**3-**Polymerfilm-**2**-Anordnung aus Figur 1a. Figur 1b veranschaulicht, dass die positiven Ladungen auf dem einen Polymerfilm **1** und die negativen Ladungen auf dem anderen Polymerfilm **2** lokalisiert sind.

Figur 1c zeigt, dass bei einem erfmdungsgemäßen Wandler aus Fig. 1a und 1b jeder Polymerfilm **1, 2** eine Elektrode **4, 5** kontaktiert. Im Rahmen der in Figur 1c gezeigten Ausführungsform sind die Elektroden **4, 5** als Elektrodenmaterialschicht auf der Seite eines Polymerfilms **1, 2** ausgebildet, welche der an die Faserschicht **3** angrenzenden Seite des Polymerfilms gegenüberliegt.

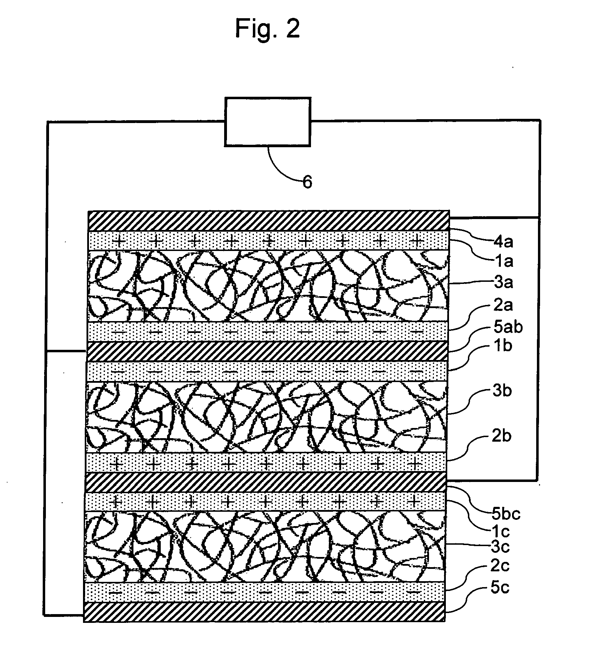

Figur 2 zeigt einen schematischen Querschnitt durch einen erfindungsgemäßen Wandler mit drei aufeinander gestapelten Polymerfilm-**1**-Faserschicht-3-Polymerfilm-**2**-Einheiten. Figur 2 veranschaulicht, dass zwei benachbarte Polymerfilme **2a, 1b; 2b, 1c** unterschiedlicher Polymerfilm-**1**-Faserschicht-**3**-Polymerfilm-**2**-Einheiten mit einer gleichen Polarisation aufgeladen sind und dabei die gleiche Elektrode **5ab, 5bc** kontaktieren. Figur 2 zeigt darüber hinaus eine Möglichkeit des Anschlusses der Elektroden **4a, 5ab, 5bc, 5c** an eine Spannungs/Strom-Mess/Versorgungs/Speicher-Vorrichtung **6.**

### Beispiele

Als Polymerfilme wurden dünne, kompakte Polycarbonatfilme mit einer Filmdicke von etwa 40 µm mittels Lösungsrakeln, insbesondere mit Dichlormethan und/oder Chloroform als Lösungsmittel, hergestellt. Die Polycarbonatfilme wurden vorsichtig getrocknet, um das verbleibende Lösungsmittel vollständig zu entfernen.

Als Faserschicht wurde anschließend mittels Elektroverspinnen einer Polycarbonatlösung eine Polycarbonatfaservliesmembran direkt auf einen gerakelten Polycarbonatfilm aufgebracht.

Zum Elektroverspinnen von Polycarbonat wurden dabei reine und gemischte Lösungsmittelsysteme aus Tetrahydrofuran, Dimethylformamid, Dichlormethan und Chloroform verwendet. Die Polymerkonzentration betrug zwischen 15 Gewichtsprozent und 20 Gewichtsprozent. Die Spannung betrug zwischen 25 kV und 30 kV, die Flussrate zwischen 0,01 ml/min und 0,5 ml/min und der Abstand zwischen Spitze und Kollektor betrug zwischen 10 cm und 25 cm.

Als zweiter Polymerfilm wurde anschließend auf der Polycarbonatfaservliesmembran ein weiterer gerakelter Polycarbonatfilm angeordnet. Die resultierende Dreischicht-Komposit-Anordnung wurde zwischen zwei heißen, sich drehenden Zylindern zusammengefügt. Dabei wurden der Druck und die Temperatur gerade so hoch gewählt, dass sich die kompakten Filme mit der Polycarbonatfaservliesmembran verbinden, während die Faserstruktur der Polycarbonatfaservliesmembran erhalten bleibt.

Anschließend wurde die Anordnung mit einer Zweielektroden-Corona-Anordnung mit einer Nadelspannung von mindestens 25 kV und Aufladezeiten von wenigstens 30 s aufgeladen.

Die nach diesem Verfahren hergestellten, erfindungsgemäßen Dreischicht-Komposit-Anordnungen zeigten 48 Stunden nach dem Aufladen einen quasistatischen piezoelektrischen Koeffizienten von ≥ 600 pC/N bis ≤ 1000 pC/N.

## Patentansprüche

1. Ein elektromechanischer Wandler, aufweisend
- mindestens zwei Elektroden (4, 5),
- mindestens zwei Polymerfilme (1, 2), die eine Ladung mit unterschiedlichem Vorzeichen aufweisen, und
- mindestens eine Faserschicht (3),
wobei eine Faserschicht (3) zwischen zwei Polymerfilmen (1, 2) angeordnet ist, wobei jeder Polymerfilm (1, 2) eine Elektrode (4, 5) kontaktiert,
**dadurch gekennzeichnet, dass**
die Faserschicht (3) aus einem unfluorierten Polymer oder aus einer Mischung aus mehreren unfluorierten Polymeren ausgebildet ist und/oder die Polymerfilme (1, 2) aus einem unfluorierten Polymer oder aus einer Mischung aus mehreren unfluorierten Polymeren ausgebildet sind.

2. Wandler nach Anspruch 1, **dadurch gekennzeichnet, dass** die Faserschicht (3) ein faserhaltiger Textilstoff ist.

3. Wandler nach Anspruch 1, **dadurch gekennzeichnet, dass** die Faserschicht (3) ein Gewebe, Gestrick, Gewirk, Vliesstoff, Filz oder Spinnfaservlies ist.

4. Wandler nach Anspruch 1, **dadurch gekennzeichnet, dass** die Faserschicht (3) eine mittels Elektrospinnen hergestellte Faserschicht ist.

5. Wandler nach Anspruch 1, **dadurch gekennzeichnet, dass** die Faserschicht (3) aus einem Elastomer ausgebildet ist.

6. Wandler nach Anspruch 1, **dadurch gekennzeichnet, dass** die Polymerfilme (1, 2) eine Filmdicke von ≥ 10 µm bis ≤ 150 µm aufweisen.

7. Wandler nach Anspruch 1, **dadurch gekennzeichnet, dass** die Polymerfilme (1, 2) unabhängig voneinander aus einem Polycarbonat, einem aromatischen Polyether oder einem Polyetherimid oder aus einer Mischung davon ausgebildet sind.

8. Wandler nach Anspruch 1, **dadurch gekennzeichnet, dass** die Polymerfilme (1, 2) unabhängig voneinander aus einem Polycarbonat, aus Polyphenylenoxid oder aus Polyetherimid oder aus einer Mischung davon ausgebildet sind.

9. Wandler nach Anspruch 1, **dadurch gekennzeichnet, dass** die Polymerfilme (1, 2) unabhängig voneinander aus einem Homopolymeren ausgebildet sind.

10. Wandler nach Anspruch 1, **dadurch gekennzeichnet, dass** das Polymer oder das Polymergemisch der Polymerfilme (1, 2) mindestens ein Additiv zur Verbesserung der Elektret- und/oder elektromechanischen Eigenschaften umfasst.

11. Wandler nach Anspruch 1, **dadurch gekennzeichnet, dass** der Wandler zwei oder mehr aufeinander gestapelte Polymerfilm-Faserschicht-Polymerfilm-Einheiten (1a-3a-2a, 1b-3b-2b, 1c-3c-2c) aufweist.

12. Verfahren zur Herstellung eines Wandlers nach Anspruch 1, umfassend die Verfahrensschritte:
a) Bereitstellen von mindestens zwei Polymerfilmen (1, 2),
b) gegebenenfalls Tempern der Polymerfilme (1, 2),
c1) Bereitstellen mindestens einer Faserschicht (3),
c2) Anordnen einer Faserschicht (3) auf einem der Polymerfilme (2),
c3) Anordnen eines zweiten Polymerfilms (1) auf der Faserschicht-(3)-Polymerfilm-(2)-Anordnung
d) Zusammenfügen der Polymerfilm-(1)-Faserschicht-(3)-Polymerfilm-(2)-Anordnung unter Anwendung eines erhöhten Drucks und/oder einer erhöhten Temperatur, und
e) Aufladen der Polymerfilm-(1)-Faserschicht-(3)-Polymerfilm-(2)-Anordnung,
wobei die Elektroden (4, 5) bereits mit den Polymerfilme (1, 2) bereitgestellt werden oder nach dem Anordnen oder nach dem Zusammenfügen oder nach dem Aufladen in Kontakt mit den Polymerfilmen (1, 2) gebracht werden.

13. Verfahren nach Anspruch 12, **dadurch gekennzeichnet, dass** die Verfahrensschritte c1) und c2) in einem Verfahrensschritt durchgeführt werden, indem die Faserschicht (3) mittels eines Verfahrens zur Herstellung von Fasern direkt auf einem der Polymerfilme (2) aufgebracht wird.

14. Verfahren nach Anspruch 12, **dadurch gekennzeichnet, dass** die Faserschicht (3) mittels Elektroverspinnen einer Polymerlösung oder Polymerschmelze direkt auf einem der Polymerfilme (2) aufgebracht wird.

15. Verwendung eines polarisierten und/oder aufgeladenen Polycarbonats, eines polarisierten und/oder aufgeladenen aromatischen Polyethers oder eines polarisierten und/oder aufgeladenen Polyetherimids oder einer Mischung davon, als Elektret in einem elektromechanischen Wandler.
